# FASCICULE DE BREVET EUROPEEN

(11) **EP 4 078 219 B1**
(45) Date de publication et mention de la délivrance du brevet: **03.01.2024**
(21) Numéro de dépôt: 20835812.7
(22) Date de dépôt: 18.12.2020
(51) Int. Cl.: G01S 7/481, G01S 17/42, G02B 26/08, G02B 26/10, H01L 21/00

(54) **COMPOSANT OPTOÉLECTRONIQUE COMPRENANT SUR UN SUBSTRAT UNIQUE UN TRANSDUCTEUR OPTIQUE EN MATÉRIAU SEMI-CONDUCTEUR III-V ET UN MICROSYSTÈME ÉLECTROMÉCANIQUE À BALAYAGE OPTIQUE**
OPTOELEKTRONISCHES BAUELEMENT, DAS AUF EINEM EINZIGEN SUBSTRAT EINEN OPTISCHEN WANDLER AUS EINEM HALBLEITERMATERIAL III-V UND EIN OPTISCH ABTASTENDES MIKROELEKTROMECHANISCHES SYSTEM UMFASST
OPTOELECTRONIC COMPONENT COMPRISING, ON A SINGLE SUBSTRATE, AN OPTICAL TRANSDUCER MADE OF A SEMI-CONDUCTOR MATERIAL III-V AND AN OPTICALLY SCANNING MICROELECTROMECHANICAL SYSTEM

(30) Priorité: 19.12.2019 FR 1914860
(43) Date de publication de la demande: 26.10.2022
(73) Titulaire: THALES, 92190 Meudon (FR)
(72) Inventeur: DUPORT, François, 91767 Palaiseau Cedex (FR); DUAN, Guang-Hua, 92330 Sceaux (FR); VAN DIJK, Frédéric, 91120 Palaiseau (FR); DELAGE, Sylvain, 91400 Orsay (FR)
(74) Mandataire: Atout PI Laplace
(86) Numéro de dépôt international: PCT/EP2020/087289
(87) Numéro de publication internationale: WO 2021/123359

(56) Documents cités:
- US-A- 6 002 507
- US-A1- 2015 103 321
- J. C. HULME ET AL: "Fully integrated hybrid silicon two dimensional beam scanner", OPTICS EXPRESS, vol. 23, no. 5, 25 février 2015 (2015-02-25), page 5861, XP055455951, DOI: 10.1364/OE.23.005861

## Description

L'invention se situe dans le domaine des dispositifs optoélectroniques assurant les fonctions de transduction optique et de déflection mécaniques de faisceau lumineux. On entend par transducteur optique un composant qui transforme un signal électrique en signal optique ou l'inverse. A titre d'exemple, un transducteur optique d'émission peut être un laser et un transducteur optique de réception une photodiode.

L'association d'un transducteur optique et de moyens de déflexion a de très nombreuses applications. A titre d'exemple, ce type de dispositif peut être utilisé dans la réalisation de systèmes LiDAR, acronyme de l'expression anglo-saxonne « Light Détection And Ranging » signifiant « détection et estimation de la distance par la lumière», de systèmes de projection d'image, ou encore de systèmes de télécommunications optiques en espace libre.

Plusieurs solutions existent pour réaliser la déflexion du faisceau optique. Une première solution consiste à réaliser la déflexion par un système optique interférentiel. La lumière est alors dirigée dans une direction de l'espace donnée en fonction de sa longueur d'onde. De manière générale, il s'agit de séparer le signal optique en plusieurs points lumineux et d'imposer un déphasage entre ces points. Les interférences entre les signaux provenant de ces différents points sont constructives dans une direction donnée. En variant le déphasage entre ces points, soit par l'utilisation de modulateurs de phase, soit en variant la longueur d'onde du laser utilisé, le système balaie la direction pointée par le faisceau optique.

Dans un tel système, les sources optiques utilisables sont nécessairement limitées et il existe de sérieuses contraintes sur le système optique interférentiel pour obtenir la rapidité et la profondeur d'accord nécessaires. Par ailleurs, ces systèmes ne permettent pas un balayage homogène de l'espace. On trouvera des informations supplémentaires sur ce type de système dans les publications de référence US2018/052378 intitulée « Optical phase array (OPA)» et dans la publication DE102015225863 intitulée « Optische phasengesteuerte Anordnung und LiDAR system ».

Une seconde solution consiste à réaliser la déflexion au moyen d'un système mécanique déplaçant un miroir dans deux directions de l'espace. Un des avantages de cette solution est qu'elle est indépendante de la longueur d'onde du rayonnement émis ou reçu.

Ce système mécanique peut être un microsystème électromécanique, connu sous le terme « MEMS », acronyme de l'expression anglo-saxonne « Micro Electro Mechanical System ». L'étape d'assemblage du système mécanique avec le transducteur nécessite une grande précision et peut être une source de défaillance si l'assemblage bouge pendant la durée de vie du dispositif, lorsque celui-ci est soumis à des contraintes d'environnement sévères. C'est le cas notamment des systèmes embarqués sur différents types de véhicules.

Une troisième solution consiste à mette en oeuvre un dispositif comportant une pluralité de sources ou de détecteurs, chaque source ou chaque détecteur pointant dans une direction de l'espace donnée. Les détecteurs ou les sources peuvent être montés en barrette ou en matrice. La publication de référence US2015131080 intitulée « Methods and Apparatus for Array Based Lidar Systems with Reduced Interférence » décrit un système de ce type.

Enfin, certains systèmes LiDAR utilisent une combinaison de ces différentes solutions pour réaliser le balayage de l'espace par le faisceau optique. On peut se référer aux systèmes décrits dans les publications de référence US2017269215 intitulée « Integrated Illumination And Détection For LIDAR Based 3-D Imaging » et de référence WO2017132704 intitulée « LIDAR based 3-D imaging with far-field illumination overlap » qui utilisent des barrettes de photodétecteurs montées sur une tourelle mobile.

Toutes les solutions existantes sont basées sur deux dispositifs distincts pour les fonctions de transduction et de balayage. Ces deux dispositifs sont en général assemblés après leur fabrication pour réaliser la fonction finale de balayage de l'espace avec un faisceau optique. La précision et la robustesse de cet assemblage est un point crucial et peut être la source de coûts élevés ainsi que de potentielles défaillances pendant la durée de vie du système, lorsque celui-ci est soumis à des environnements sévères, tant sur le plan thermique que vibratoire, notamment dans les applications embarquées sur véhicule.

Afin d'éviter ces différents inconvénients et en particulier la délicate étape d'assemblage final, le composant optoélectronique selon l'invention intègre sur une même puce électronique à la fois les fonctions de transduction et de déflexion. A cette fin, on réalise l'intégration hétérogène de matériaux III-V sur une plateforme silicium préalablement conçue afin de permettre aussi la réalisation de microsystèmes mécaniques sur silicium. Les semi-conducteurs III-V sont des matériaux composés d'un ou de plusieurs éléments de la colonne III et de la colonne V du tableau périodique de Mendeleïev. A titre d'exemples, les éléments de la colonne III sont le bore, le gallium, l'aluminium ou l'indium et ceux de la colonne V sont l'arsenic, l'antimoine ou le phosphore

Il devient alors possible de réaliser, sur la même puce, un dispositif MEMS en charge de la déflexion du faisceau optique. L'alignement optique des deux fonctions est réalisé pendant la fabrication des composants en salle blanche, à l'échelle du substrat entier ou wafer. Grâce à la précision inégalée des moyens de fabrication des composants silicium, cet alignement est très précis, bien plus précis que lorsqu'il est réalisé par l'assemblage mécanique de deux composants et ne nécessite plus d'étape de réalisation supplémentaire après la fabrication des composants.

Le temps et les coûts de fabrication ajoutés par la réalisation de MEMS sur les composants hybrides sont largement compensés par l'économie de temps liée à l'absence d'assemblage après la fabrication en salle blanche, les étapes technologiques supplémentaires étant mutualisées pour tous les composants d'un même wafer. Enfin comme il s'agit de composants monolithiques, il n'y a plus de défaillance possible de l'assemblage pendant la durée de vie du composant. De plus, un composant selon l'invention occupe une surface totale très faible, de l'ordre de quelques millimètres carrés. Ainsi, sur une galette d'un diamètre de 100 millimètres, il est possible de réaliser simultanément un millier de composants.

Plus précisément, l'invention a pour objet un composant optoélectronique comprenant un transducteur optique en matériau semi-conducteur III-V et un microsystème électromécanique à balayage optique comportant un miroir, caractérisé en ce que le transducteur optique et le microsystème électromécanique à balayage optique sont réalisés dans une plaquette commune comportant au moins une première couche en silicium ou en nitrure de silicium d'épaisseur inférieure au micron dans laquelle sont réalisés au moins le miroir et ses ressorts de maintien.

La plaquette, dans laquelle sont formés le transducteur et le microsystème électromécanique à balayage optique, est constituée d'un empilement de couches comprenant chacune du silicium et d'une couche de matériau III - V.

Le MEMS et le transducteur optique sont formés dans des couches de cette plaquette. Autrement dit, les couches comprennent ces éléments et les couches respectives sont monobloc.

Avantageusement, la plaquette comprend, dans cet ordre, la couche de matériau semi-conducteur III-V, la première couche en silicium ou en nitrure de silicium d'épaisseur inférieure au micron et une deuxième couche en oxyde de silicium. Le composant optoélectronique comprend un guide optique compris dans la première couche et la deuxième couche.

Dans un premier mode de réalisation, la plaquette commune comporte, dans cet ordre, une couche de matériau semi-conducteur III-V, la première couche en silicium ou en nitrure de silicium, une seconde couche en oxyde de silicium, une troisième couche en silicium, une quatrième couche en oxyde de silicium et un substrat, le transducteur optique comportant un guide optique étant réalisé dans la première couche et la seconde couche, des parties mobiles du microsystème électromécanique à balayage optique étant réalisées dans la troisième couche et la quatrième couche.

Avantageusement, une couche de report en oxyde de silicium est disposée entre la couche de matériau semi-conducteur III-V et la première couche en silicium ou en nitrure de silicium.

Avantageusement, l'épaisseur de la seconde couche est comprise entre 3 microns et 4 microns, l'épaisseur de la troisième couche est comprise entre 10 microns et 100 microns et l'épaisseur de la quatrième couche est comprise entre 3 microns et 4 microns.

Dans un deuxième mode de réalisation, la plaquette commune comporte, dans cet ordre, une couche de matériau semi-conducteur III-V, la première couche en silicium ou en nitrure de silicium, une seconde couche en oxyde de silicium et un substrat, le transducteur optique comportant un guide optique étant réalisé dans la première couche et la seconde couche, les parties mobiles du microsystème électromécanique à balayage optique étant réalisées dans la couche de matériau semi-conducteur III-V.

Avantageusement, une couche de report en oxyde de silicium est disposée entre la couche de matériau semi-conducteur III-V et la première couche en silicium ou en nitrure de silicium.

Avantageusement, l'épaisseur de la seconde couche est comprise entre 3 microns et 4 microns.

Avantageusement, les ressorts de maintien sont deux lames planes identiques ayant sensiblement la forme de rectangles allongés situés de part et d'autre du miroir, le miroir étant relié auxdites lames par une attache unique, les parties mobiles sont constituées de deux poutres identiques, parallèles entre elles, chaque poutre étant reliée à un ensemble de peignes interdigités pilotés en tension de façon à assurer le déplacement de chaque poutre dans une même direction donnée ; chaque lame est solidaire d'une des deux poutres et se déplace avec elle, le déplacement des poutres entraînant un flambage des lames en butée sur le guide optique, un flambage conjoint des deux lames assurant l'inclinaison du miroir dans une première direction, un flambage différentiel des deux lames assurant l'inclinaison du miroir dans une seconde direction.

Avantageusement, le transducteur optique est un laser.

Avantageusement, le transducteur optique est une photodiode.

Avantageusement, la plaquette est constituée de couches comprenant chacune du silicium et de la couche de matériau semi-conducteur III-V.

D'autres caractéristiques, détails et avantages de l'invention ressortiront à la lecture de la description faite en référence aux dessins annexés donnés à titre d'exemple et qui représentent, respectivement :
[Fig.1] une illustration de l'empilement des couches de matériaux nécessaires à la réalisation d'un premier composant électronique selon l'invention ;
[Fig.2] une vue de dessus d'un composant électronique selon l'invention ;
[Fig.3] une vue de côté d'un premier composant électronique selon l'invention en l'absence de sollicitations des peignes interdigités ;
[Fig.4] une vue de côté du premier composant électronique selon l'invention en présence de sollicitations des peignes interdigités ;
[Fig.5] une vue partielle agrandie de la figure 4 ;
[Fig.6] une illustration de l'empilement des couches de matériaux nécessaires à la réalisation d'un second composant électronique selon l'invention ;
[Fig.7] une vue de côté d'un second composant électronique selon l'invention en l'absence de sollicitations des peignes interdigités ;
[Fig.8] une vue de côté du second composant électronique selon l'invention en présence de sollicitations des peignes interdigités.

Le composant optoélectronique selon l'invention comprend un transducteur optique en matériau semi-conducteur III-V et un microsystème électromécanique noté MEMS à balayage optique comportant un miroir. Le transducteur optique et le microsystème électromécanique à balayage optique sont réalisés dans une plaquette commune comportant au moins une première couche en silicium ou en nitrure de silicium d'épaisseur inférieure au micron dans laquelle sont réalisés au moins le miroir et ses ressorts de maintien.

La première couche de silicium ou en nitrure de silicium présente avantageusement une épaisseur supérieure ou égale à 300 nm.

La première couche en silicium ou en nitrure de silicium est monobloc et comprend le miroir et ses ressorts de maintien.

La plaquette comprend la première couche en silicium ou en nitrure de silicium et une deuxième couche en oxyde de silicium. Un guide optique est compris dans ces deux couches.

Le guide optique comprend une structure optique formée dans la première couche en silicium ou en nitrure de silicium et la deuxième couche en oxyde de silicium qui participe au confinement du mode optique.

Avantageusement, le guide optique est formé de sorte à guider la lumière dans le plan de la première couche en silicium.

La réalisation du guide optique au sein d'une même couche que le miroir et ses ressorts permet d'obtenir un composant de taille réduite, d'éviter une étape de dépôt ou de croissance d'une couche supplémentaire.

Elle permet également de réaliser un alignement précis du miroir avec le guide optique et de réaliser une émission ou réception aussi bien selon une direction perpendiculaire au plan de la première couche que selon une direction du plan de la première couche. En effet, le guide optique permet de guider la lumière dans le plan de la couche. Le miroir permet de diriger la lumière dans toutes les directions hors du plan de la couche et dans le plan de la couche.

Il existe notamment deux modes de réalisation possibles du composant. Dans un premier mode de réalisation, les parties mobiles du microsystème électromécanique à balayage optique sont réalisées dans des couches de silicium ou d'oxyde de silicium. Dans un second mode de réalisation, les parties mobiles du microsystème électromécanique à balayage optique sont réalisées dans la couche de matériau semi-conducteur III-V.

Le transducteur optique peut être soit un émetteur de lumière, soit un récepteur de lumière. Dans le premier cas, l'émetteur est un laser. Dans le second cas, le récepteur est une photodiode. Dans ce qui suit, le terme de transducteur recouvre ses deux fonctions.

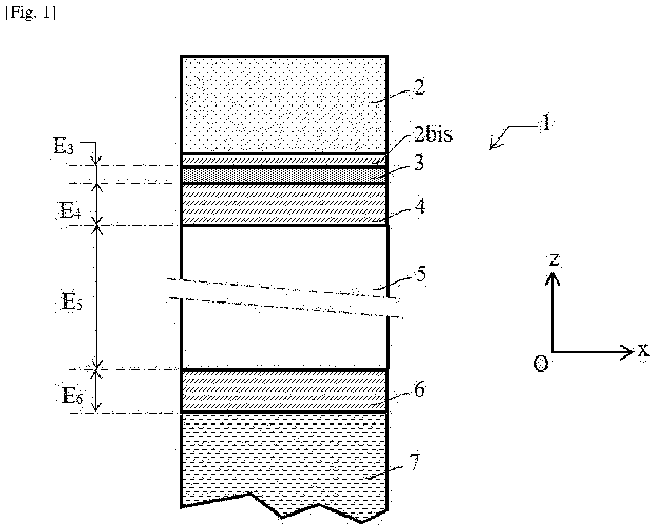

A titre de premier exemple de réalisation, la figure 1 représente l'empilement des couches nécessaires à la réalisation d'un composant selon l'invention dans un premier mode de réalisation. Cette figure et les suivantes sont référencées dans un repère tridimensionnel (O, x, y, z). Le plan de coupe de la figure 1 est dans un plan (O, x, z). En partant de l'extérieur du composant 1 jusqu'au substrat qui lui sert de support, on trouve successivement :
- une couche 2 de matériau III-V,
- une fine couche de report 2bis d'oxyde de silicium d'une centaine de nanomètres qui permet de réaliser le report de la couche 2 précédente sur la couche suivante 3,
- une première couche 3 en silicium ou en nitrure de silicium dont l'épaisseur E₃ est de l'ordre de 500 nanomètres,
- une deuxième couche 4 en oxyde de silicium dont l'épaisseur E₄ est comprise entre 3 microns et 4 microns,
- une troisième couche 5 en silicium dont l'épaisseur E₅ est comprise entre 10 microns et 100 microns,
- une quatrième couche 6 en oxyde de silicium dont l'épaisseur E₆ est comprise entre 3 microns et 4 microns,
- le substrat 7 proprement dit en silicium.

Le transducteur est réalisé en matériau III-V tel que du phosphure d'indium ou InP dans lequel des puits quantiques sont intégrés. Ce matériau est ensuite reporté sur le substrat en silicium. Le ou les guides optiques sont fabriqués dans la première couche 3 en silicium ou en nitrure de silicium.

Le miroir 30 et ses ressorts de maintien 31 sont réalisés dans la première couche 3 en silicium ou en nitrure de silicium.

La deuxième couche 4 en oxyde de silicium située juste sous cette première couche de silicium ou de nitrure de silicium 3 participe au confinement du mode optique. Autrement dit, la deuxième couche 4 est contigüe à la première couche 3. La deuxième couche 4 forme une paroi du guide optique.

La troisième couche de silicium beaucoup plus épaisse est utilisée pour réaliser les actionneurs du dispositif MEMS de déflexion du faisceau lumineux émis ou reçu selon que le transducteur est un émetteur ou un récepteur.

En particulier, des parties mobiles 23, 24, 25 du dispositif MEMS sont réalisées dans la troisième couche 5 de silicium. Les parties mobiles 23, 24, 25 sont aptes à actionner, c'est-à-dire, entraîner mécaniquement le miroir 30 et ses ressorts 31.

La troisième couche 5, comprenant les parties mobiles 23, 24, 25 est monobloc.

Pour réaliser le composant, il est nécessaire d'utiliser des galettes de semi-conducteur connues sous le nom de « wafers » particuliers. Il s'agit de wafers de silicium possédant deux couches d'oxyde de silicium enterrées. Ainsi, le ou les guides optiques sont réalisés dans la couche supérieure de silicium ou de nitrure de silicium et les structures mécaniques sont réalisées dans la couche intermédiaire en silicium.

Une solution pour obtenir de tels wafers est d'utiliser un wafer classique dit silicium sur isolant ou « SOI » acronyme de l'expression anglo-saxonne « Silicon On Insulator » pour réaliser les structures du MEMS. Ces wafers sont disponibles commercialement. Ce wafer comporte le substrat en silicium, la couche d'oxyde de silicium de quelques microns d'épaisseur et la couche supérieure de silicium de quelques dizaines de microns d'épaisseur qui servira à réaliser la structure mécanique MEMS. Sur ce wafer, on fait croitre une nouvelle couche d'oxyde de silicium de 3 à 4 microns d'épaisseur, obtenue par l'oxydation du silicium superficiel dans un four adapté. Sur cette dernière couche d'oxyde de silicium, on dépose la couche guidante en silicium ou en nitrure de silicium.

Les composants III-V sont réalisés de façon classique en commençant par la structuration des guides optiques et des fonctions réalisées dans le silicium ou le nitrure de silicium supérieur, puis le report des matériaux III-V et leur agencement. Ces étapes de fabrication se font jusqu'à leur terme avec les métallisations nécessaires, compte-tenu de la définition des facettes de sortie optiques des composants.

Les parties du wafer comportant les composants III-V sur silicium ou nitrure de silicium et en particulier les facettes de sortie des composants sont alors protégées par de la résine ou éventuellement de la photo-résine.

On réalise enfin les dispositifs mécaniques des MEMS et du miroir. Cette réalisation comporte les étapes suivantes :
- Découpe du miroir dans la couche supérieure de silicium par photolithographie et attaque du silicium ;
- Réalisation des actionneurs MEMS par masquage et gravure ionique réactive profonde, gravure connue sous le nom de « DRIE », signifiant « Deep Reactive Ion Etching » ;
- Réalisation des décaissements nécessaires sous le miroir par masquage et attaque isotrope ;
- Métallisation des structures MEMS et du miroir ;
- Libération des parties mobiles et du miroir par attaque à l'acide fluorhydrique ou HF des deux couches d'oxyde de silicium.

Une fois les structures MEMS et les miroirs réalisés, on retire la résine de protection des composants III-V déposée avant les étapes de fabrication des MEMS.

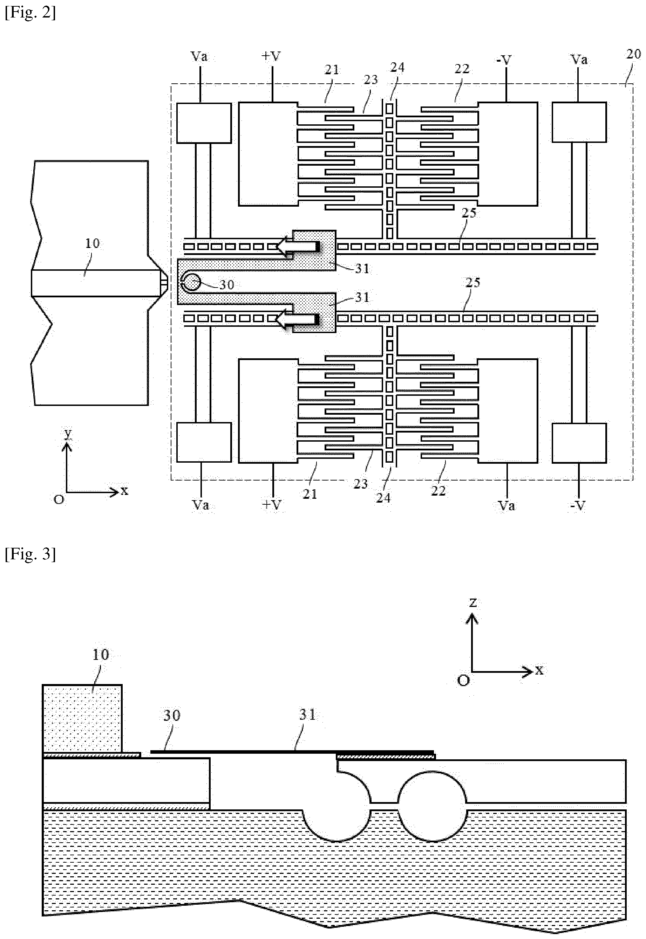

Il existe différentes configurations pour réaliser le microsystème électromécanique à balayage à miroir selon l'invention. A titre d'exemple non limitatif, la figure 2 représente une vue de dessus du composant selon l'invention comportant son transducteur 10 et son microsystème électromécanique 20. Cette vue est dans un plan de coupe (O, x, y).

Le microsystème électromécanique 20 comporte deux actionneurs identiques et un ensemble d'un seul tenant réalisé dans la première couche comprenant le miroir 30 et ses deux ressorts de maintien 31. Cet ensemble est représenté en gris sur la figure 2.

Chaque actionneur est constitué de deux peignes fixes 21 et 22 identiques et symétriques l'un par rapport à l'autre et un double peigne mobile 23 comprenant une poutrelle centrale 24. Les dents du peigne mobile sont entrelacées avec celles des deux peignes fixes.

La poutrelle centrale 24 est reliée à une seconde poutrelle 25, perpendiculaire à ladite poutrelle 24. Les deux poutrelles 25 des deux actionneurs sont parallèles entre elles. Chacune de ces deux poutrelles 25 est reliée à un des deux ressorts de maintien 31.

Les peignes fixes et le peigne mobile des actionneurs sont commandés en tension. Les tensions de commande des parties fixes sont de quelques dizaines de volts. A titre exemple, les tensions de commande +V et -V de la figure 2 sont de +50 V sur le premier peigne fixe et de -50 V sur le second peigne fixe. Les tensions de commande Va du peigne mobile sont de quelques volts.

La commande d'un actionneur en tension entraîne le déplacement en translation du peigne mobile et, par conséquent, celui de la poutrelle 25 qui se déplace dans le sens de sa longueur. Les déplacements sont représentés par des flèches blanches sur la figure 2 et les suivantes.

Chaque ressort de maintien 31 comporte une lame en forme de rectangle allongé relié au miroir 30 par une liaison de très faible largeur. Compte-tenu de leur très faible épaisseur, les lames possèdent une certaine élasticité et peuvent ainsi flamber facilement. Sur la figure 2, le miroir 30 est de forme circulaire.

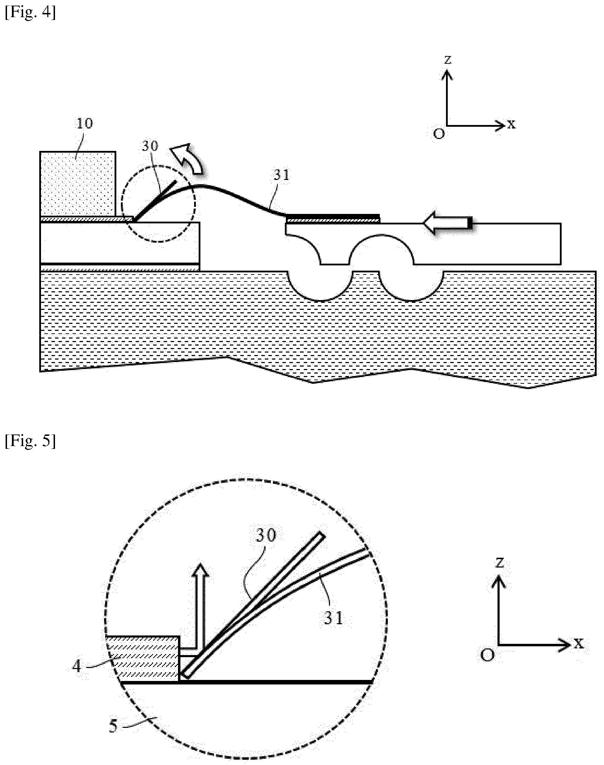

Le fonctionnement du dispositif est représenté sur les figures 3, 4 et 5, la figure 5 représentant une vue partielle agrandie de la figure 4. Sur la figure 5, la flèche blanche en forme d'équerre représente la déviation du faisceau lumineux par le miroir lorsque le transducteur est un laser.

La figure 3 représente une vue de côté du miroir 30 et de ses ressorts de maintien 31 en l'absence de sollicitations des peignes interdigités. Cette vue de côté est représentée dans un plan de coupe (O, x, z). Le miroir et ses ressorts sont dans un plan horizontal, parallèle à l'axe x. Aucune déflexion n'a lieu.

La figure 4 représente une vue de côté du miroir et de ses ressorts de maintien en présence de sollicitations des peignes interdigités. L'application des tensions de commande entraîne le déplacement des deux ressorts comme on le voit sur cette figure 4 qui viennent en butée sous la première couche de silicium ou de nitrure de silicium disposée sous le transducteur III-V de référence 10.

Ce guidage en butée est assuré par une différence de potentiel appliquée entre la deuxième couche et la troisième couche de silicium épaisse. La zone du miroir est ainsi positionnée sous la couche de silicium utilisée pour le guidage optique. Si l'on continue le déplacement, les lames des ressorts flambent entraînant le miroir en rotation.

Si les déplacements des deux ressorts sont identiques, le miroir tourne autour de l'axe y et se redresse comme on le voit sur les figures 4 et 5. Si les déplacements des deux miroirs sont différents, le miroir tourne autour de l'axe z. Ainsi, on peut obtenir simplement en jouant sur les tensions de commande, une orientation du miroir selon deux axes différents permettant la déflexion d'un faisceau lumineux émis ou reçu selon ces deux axes. Connaissant la relation qui lie les tensions de commande aux orientations du miroir, on peut ainsi obtenir la déflexion souhaitée.

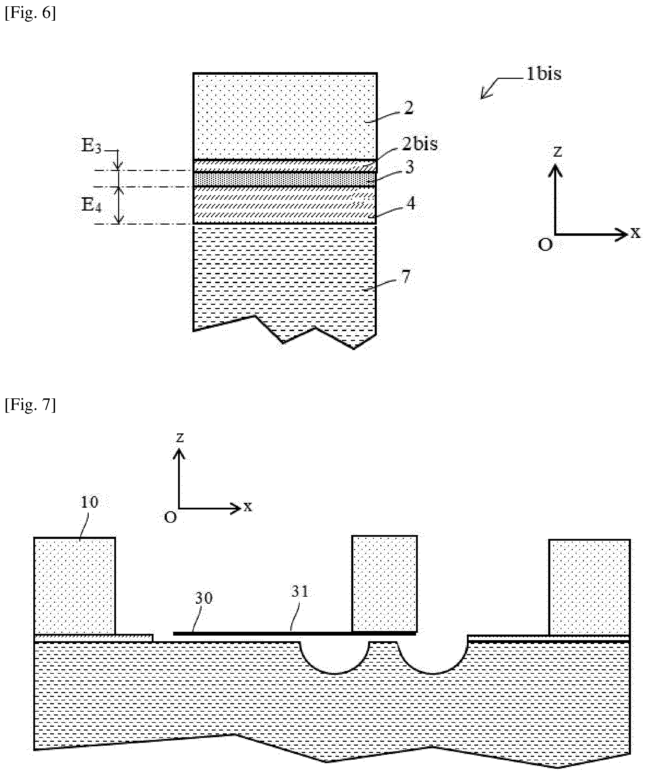

A titre de second exemple de réalisation, la figure 6 représente l'empilement des couches nécessaires à la réalisation d'un composant selon l'invention dans un second mode de réalisation. Le plan de coupe de la figure 6 est dans un plan (O, x, z). En partant de l'extérieur du composant 1 bis jusqu'au substrat qui lui sert de support, on trouve successivement :
- une couche 2 de matériau III-V,
- une fine couche de report 2bis d'oxyde de silicium d'une centaine de nanomètres qui permet de réaliser le report de la couche 2 précédente sur la couche suivante 3,
- une première couche 3 en silicium ou en nitrure de silicium dont l'épaisseur est de l'ordre de 500 nanomètres,
- une deuxième couche 4 en oxyde de silicium dont l'épaisseur est comprise entre 3 microns et 4 microns,
- le substrat 7 proprement dit en silicium.

Comme dans la première réalisation précédente, le transducteur est réalisé en matériau III-V tel que du phosphure d'indium ou InP dans lequel des puits quantiques sont intégrés. Ce matériau est ensuite reporté sur le substrat en silicium. Les guides optiques sont fabriqués dans la première couche 3 en silicium ou en nitrure de silicium.

La deuxième couche 4 en oxyde de silicium située juste sous cette première couche 3 de silicium ou de nitrure de silicium participe au confinement du mode optique. Autrement dit, la deuxième couche 4 délimite le guide optique.

La différence essentielle avec le premier mode de réalisation est que le dispositif mécanique 21, 22, 23, 24, 25 de déflexion du faisceau lumineux est réalisé dans la couche III-V. Par dispositif mécanique de déflexion du faisceau lumineux, on entend les actionneurs 21, 22, 23, 24, 25 du dispositif MEMS, c'est-à-dire les actionneurs du miroir 30 et de ses ressorts 31. La couche de matériau III - V est monobloc.

Celui-ci peut comporter les mêmes composants que le dispositif de déflexion précédent représenté sur la figure 2. Les composants sont agencés de la même façon mais les actionneurs 21, 22, 23, 24, 25 sont réalisés dans la couche de matériau III-V. Ils comprennent, comme dans le cas précédent, une structure symétrique à peignes interdigités reliée par des poutrelles à un ensemble comprenant deux lames de ressort 31 supportant un miroir 30 disposé devant le transducteur.

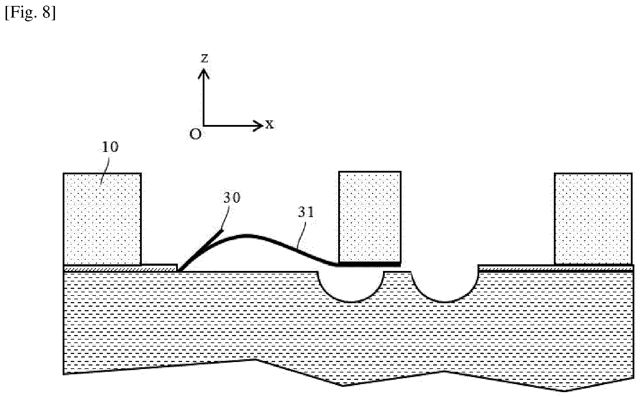

Le fonctionnement du dispositif est indiqué sur les figures 7 et 8 qui représentent une vue de côté du miroir et de ses ressorts de maintien en l'absence et en présence de sollicitations des peignes interdigités. Cette vue de côté est représentée dans un plan de coupe (O, x, z). Comme dans la précédente réalisation, le miroir et ses ressorts sont réalisés dans la couche mince de silicium ou de nitrure de silicium. Le mécanisme d'orientation du miroir est le même. En appliquent des tensions de commande identiques ou différentes sur les actionneurs, on oriente le miroir selon deux axes différents.

Le guidage en butée du miroir est assuré par une différence de potentiel appliquée entre la deuxième couche et le substrat.

Un des intérêts de ce second mode de réalisation par rapport au précédent est que, dans la mesure où le nombre de couches nécessaires est inférieur au premier mode de réalisation, les composants peuvent être implantés sur des wafers standard de conception plus simples, déjà utilisés pour la réalisation de composants III-V intégrés de manière hétérogène sur un wafer standard. Si nécessaire, le substrat en silicium peut être gravé et utilisé pour réaliser des parties nécessitant des propriétés mécaniques adaptées.

La réalisation de ce type de composants comporte les étapes suivantes :
- Réalisation des structures mécaniques en matériaux III-V avec trois étapes de masquages, attaques DRIE et attaques isotropes pour les décaissements ;
- Réalisation du miroir et de ses ressorts de maintien en dégageant les couches supérieures jusqu'à la couche de silicium ou nitrure de silicium puis par masquage, attaque RIE et attaque isotrope pour définir le miroir et ses ressorts de maintien et préparer leur libération ;
- Métallisation des structures MEMS pour la prise de contact électrique et la définition des miroirs mobiles ;
- Attaque à l'acide HF permettant de libérer les parties mobiles des différents dispositifs ;
- Une fois les structures du MEMS et les miroirs réalisés, retrait de la résine de protection des composants III-V déposée avant les étapes de fabrication du MEMS.
- Dans ce mode de réalisation, la couche III-V est déposée sur le wafer avant l'étape de réalisation des structures mécaniques.
- Le composant selon l'invention peut, comprendre une pluralité de transducteurs et/ou plusieurs MEMS et/ou une pluralité de guides optiques.

## Revendications

1. Composant optoélectronique (1) comprenant un transducteur optique (10) en matériau semi-conducteur III-V et un microsystème électromécanique à balayage optique (20) comportant un miroir (30) et des ressorts de maintien (31), le transducteur optique et le microsystème électromécanique à balayage optique étant réalisés dans une plaquette comprenant, dans cet ordre, une couche (2) de matériau semi-conducteur III-V, une première couche (3) en silicium ou en nitrure de silicium d'épaisseur inférieure au micron dans laquelle sont réalisés au moins le miroir (30) et ses ressorts de maintien (31), une deuxième couche (4) en oxyde de silicium, le composant optoélectronique comprenant un guide optique compris dans la première couche (3) en silicium ou en nitrure de silicium et la deuxième couche (4) en oxyde de silicium.

2. Composant optoélectronique selon la revendication 1, **caractérisé en ce que** la plaquette commune comporte, dans cet ordre, la couche (2) de matériau semi-conducteur III-V, la première couche (3) en silicium ou en nitrure de silicium, la deuxième couche (4) en oxyde de silicium, la troisième couche (5) en silicium, la quatrième couche (6) en oxyde de silicium et un substrat (7), le microsystème électromécanique à balayage optique comprenant des parties mobiles (23, 24, 25) réalisées dans la troisième couche (5) en silicium et la quatrième couche (6) en oxyde de silicium.

3. Composant optoélectronique selon la revendication 2, **caractérisé en ce qu'**une couche (2bis) de report en oxyde de silicium est disposée entre la couche (2) de matériau semi-conducteur III-V et la première couche (3) en silicium ou en nitrure de silicium.

4. Composant optoélectronique selon l'une quelconque des revendications 2 à 3, **caractérisé en ce que** l'épaisseur de la deuxième couche (4) en oxyde de silicium est comprise entre 3 microns et 4 microns, l'épaisseur de la troisième couche (5) en silicium est comprise entre 10 microns et 100 microns et l'épaisseur de la quatrième couche (6) en oxyde de silicium est comprise entre 3 microns et 4 microns.

5. Composant optoélectronique selon la revendication 1, **caractérisé en ce que** la plaquette commune comporte, dans cet ordre, la couche (2) de matériau semi-conducteur III-V, la première couche (3) en silicium ou en nitrure de silicium, la deuxième couche (4) en oxyde de silicium et un substrat (7), le microsystème électromécanique à balayage optique comprenant des parties mobiles (23, 24, 25) réalisées dans la couche de matériau semi-conducteur III-V.

6. Composant optoélectronique selon la revendication 5, **caractérisé en ce qu'**une couche (2bis) de report en oxyde de silicium est disposée entre la couche (2) de matériau semi-conducteur III-V et la première couche (3) en silicium ou en nitrure de silicium.

7. Composant optoélectronique selon l'une quelconque des revendications 5 à 6, **caractérisé en ce que** l'épaisseur de la deuxième couche (4) en oxyde de silicium est comprise entre 3 microns et 4 microns.

8. Composant optoélectronique selon l'une des revendications 2 à 7, **caractérisé en ce que** :
- les ressorts de maintien (31) sont deux lames planes identiques ayant sensiblement la forme de rectangles allongés situés de part et d'autre du miroir, le miroir étant relié auxdites lames par une attache unique ;
- les parties mobiles sont constituées de deux poutres (25) identiques, parallèles entre elles, chaque poutre étant reliée à un ensemble de peignes (23) interdigités pilotés en tension de façon à assurer le déplacement de chaque poutre dans une même direction donnée ;
- chaque lame est solidaire d'une des deux poutres et se déplace avec elle, le déplacement des poutres entraînant un flambage des lames en butée sur le guide optique, un flambage conjoint des deux lames assurant l'inclinaison du miroir dans une première direction, un flambage différentiel des deux lames assurant l'inclinaison du miroir dans une seconde direction.

9. Composant optoélectronique selon l'une des revendications précédentes, **caractérisé en ce que** le transducteur optique est un laser.

10. Composant optoélectronique selon l'une des revendications 1 à 8, **caractérisé en ce que** le transducteur optique est une photodiode.

11. Composant optoélectronique selon l'une quelconque des revendications précédentes, dans lequel la plaquette est constituée de couches comprenant chacune du silicium et de la couche de matériau semi-conducteur III-V.

## Patentansprüche

1. Optoelektronisches Bauelement (1), umfassend einen optischen Wandler (10) aus III-V-Halbleitermaterial und ein elektromechanisches Mikrosystem mit optischer Abtastung (20), mit einem Spiegel (30) und Haltefedern (31), wobei der optische Wandler und das elektromechanische Mikrosystem mit optischer Abtastung in einem Wafer hergestellt sind, umfassend, in dieser Reihenfolge, eine Schicht (2) aus III-V-Halbleitermaterial, eine erste Schicht (3) aus Silizium oder Siliziumnitrid mit einer Dicke von weniger als einem Mikrometer, in der mindestens der Spiegel (30) und seine Haltefedern (31) hergestellt sind, eine zweite Schicht (4) aus Siliziumoxid, wobei das optoelektronische Bauelement einen Lichtleiter umfasst, der in der ersten Schicht (3) aus Silizium oder Siliziumnitrid und der zweiten Schicht (4) aus Siliziumoxid enthalten ist.

2. Optoelektronisches Bauelement nach Anspruch 1, **dadurch gekennzeichnet, dass** der gemeinsame Wafer in dieser Reihenfolge die Schicht (2) aus III-V-Halbleitermaterial, die erste Schicht (3) aus Silizium oder Siliziumnitrid, die zweite Schicht (4) aus Siliziumoxid, die dritte Schicht (5) aus Silizium, die vierte Schicht (6) aus Siliziumoxid und ein Substrat (7) aufweist, wobei das elektromechanische Mikrosystem mit optischer Abtastung bewegliche Teile (23, 24, 25) umfasst, die in der dritten Schicht (5) aus Silizium und der vierten Schicht (6) aus Siliziumoxid hergestellt sind.

3. Optoelektronisches Bauelement nach Anspruch 2, **dadurch gekennzeichnet, dass** eine Übertragungsschicht (2bis) aus Siliziumoxid zwischen der Schicht (2) aus III-V-Halbleitermaterial und der ersten Schicht (3) aus Silizium oder Siliziumnitrid angeordnet ist.

4. Optoelektronisches Bauelement nach einem der Ansprüche 2 bis 3, **dadurch gekennzeichnet, dass** die Dicke der zweiten Schicht (4) aus Siliziumoxid zwischen 3 Mikrometern und 4 Mikrometern liegt, die Dicke der dritten Schicht (5) aus Silizium zwischen 10 Mikrometern und 100 Mikrometern liegt und die Dicke der vierten Schicht (6) aus Siliziumoxid zwischen 3 Mikrometern und 4 Mikrometern liegt.

5. Optoelektronisches Bauelement nach Anspruch 1, **dadurch gekennzeichnet, dass** der gemeinsame Wafer in dieser Reihenfolge die Schicht (2) aus III-V-Halbleitermaterial, die erste Schicht (3) aus Silizium oder Siliziumnitrid, die zweite Schicht (4) aus Siliziumoxid und ein Substrat (7) aufweist, wobei das elektromechanische Mikrosystem mit optischer Abtastung bewegliche Teile (23, 24, 25) umfasst, die in der Schicht aus III-V-Halbleitermaterial hergestellt sind.

6. Optoelektronisches Bauelement nach Anspruch 5, **dadurch gekennzeichnet, dass** eine Übertragungsschicht (2bis) aus Siliziumoxid zwischen der Schicht (2) aus III-V-Halbleitermaterial und der ersten Schicht (3) aus Silizium oder Siliziumnitrid angeordnet ist.

7. Optoelektronisches Bauelement nach einem der Ansprüche 5 bis 6, **dadurch gekennzeichnet, dass** die Dicke der zweiten Schicht (4) aus Siliziumoxid zwischen 3 Mikrometern und 4 Mikrometern liegt.

8. Optoelektronisches Bauelement nach einem der Ansprüche 2 bis 7, **dadurch gekennzeichnet, dass**:
- die Haltefedern (31) zwei identische ebene Lamellen sind, die im Wesentlichen die Form von länglichen Rechtecken aufweisen, die sich auf beiden Seiten des Spiegels befinden, wobei der Spiegel mit den Lamellen durch eine einzige Befestigung verbunden ist;
- die beweglichen Teile aus zwei identischen, zueinander parallelen Trägern (25) bestehen, wobei jeder Träger mit einem Satz von ineinandergreifenden, spannungsgesteuerten Kämmen (23) verbunden ist, um die Bewegung jedes Trägers in eine gleiche gegebene Richtung zu gewährleisten;
- jede Lamelle fest mit einem der beiden Träger verbunden ist und sich mit diesem verschiebt, wobei die Verschiebung der Träger ein Knicken der Lamellen im Anschlag an der optischen Führung, ein gemeinsames Knicken der beiden Lamellen, das die Neigung des Spiegels in einer ersten Richtung gewährleistet, ein Differenzialknicken der beiden Lamellen, das die Neigung des Spiegels in einer zweiten Richtung gewährleistet, bewirkt.

9. Optoelektronisches Bauelement nach einem der vorhergehenden Ansprüche, **dadurch gekennzeichnet, dass** der optische Wandler ein Laser ist.

10. Optoelektronisches Bauelement nach einem der Ansprüche 1 bis 8, **dadurch gekennzeichnet, dass** der optische Wandler eine Fotodiode ist.

11. Optoelektronisches Bauelement nach einem der vorhergehenden Ansprüche, wobei der Wafer aus Schichten besteht, die jeweils Silizium und die Schicht aus III-V-Halbleitermaterial umfassen.

## Claims

1. An optoelectronic component (1) comprising an optical transducer (10) made of III-V semiconductor material and an optical scanning microelectromechanical system (20) having a mirror (30) and holding springs (31), the optical transducer and the optical scanning microelectromechanical system being produced in a wafer comprising, in this order, a layer (2) of III-V semiconductor material, a first layer (3) made of silicon or silicon nitride, with a thickness of less than one micron, in which at least the mirror (30) and its holding springs (31) are produced, a second layer (4) made of silicon oxide, the optoelectronic component comprising an optical guide comprised within the first layer (3) made of silicon or silicon nitride and the second layer (4) made of silicon oxide.

2. The optoelectronic component according to claim 1, **characterised in that** the common wafer has, in this order, the layer (2) of III-V semiconductor material, the first layer (3) made of silicon or silicon nitride, the second layer (4) made of silicon oxide, the third layer (5) made of silicon, the fourth layer (6) made of silicon oxide, and a substrate (7), the optical scanning microelectromechanical system comprising mobile parts (23, 24, 25) produced in the third layer (5) made of silicon and the fourth layer (6) made of silicon oxide.

3. The optoelectronic component according to claim 2, **characterised in that** a transfer layer (2bis) made of silicon oxide is arranged between the layer (2) of III-V semiconductor material and the first layer (3) made of silicon or silicon nitride.

4. The optoelectronic component according to any one of claims 2 to 3, **characterised in that** the thickness of the second layer (4) made of silicon oxide is between 3 microns and 4 microns, the thickness of the third layer (5) made of silicon is between 10 microns and 100 microns and the thickness of the fourth layer (6) made of silicon oxide is between 3 microns and 4 microns.

5. The optoelectronic component according to claim 1, **characterised in that** the common wafer has, in this order, the layer (2) of III-V semiconductor material, the first layer (3) made of silicon or silicon nitride, the second layer (4) made of silicon oxide, and a substrate (7), the optical scanning microelectromechanical system comprising mobile parts (23, 24, 25) produced in the layer of III-V semiconductor material.

6. The optoelectronic component according to claim 5, **characterised in that** a transfer layer (2bis) made of silicon oxide is arranged between the layer (2) of III-V semiconductor material and the first layer (3) made of silicon or silicon nitride.

7. The optoelectronic component according to any one of claims 5 to 6, **characterised in that** the thickness of the second layer (4) made of silicon oxide is between 3 microns and 4 microns.

8. The optoelectronic component according to any one of claims 2 to 7, **characterized in that**:
- the holding springs (31) are two identical flat leaves having substantially the shape of elongated rectangles located on either side of the mirror, the mirror being connected to said leaves by a single attachment;
- the mobile parts consist of two identical beams (25), parallel to one another, each beam being connected to a set of voltage-controlled interdigitated combs (23) so as to ensure the displacement of each beam in one and the same given direction;
- each leaf is integral with one of the two beams and moves therewith, the displacement of the beams causing the leaves to buckle in abutment on the optical guide, joint buckling of the two leaves tilting the mirror in a first direction, differential buckling of the two leaves tilting the mirror in a second direction.

9. The optoelectronic component according to any one of the preceding claims, **characterised in that** the optical transducer is a laser.

10. The optoelectronic component according to any one claims 1 to 8, **characterised in that** the optical transducer is a photodiode.

11. The optoelectronic component according to any one of the preceding claims, wherein the wafer consists of layers each comprising silicon and the layer of III-V semiconductor material.
